# EUROPEAN PATENT APPLICATION

(11) **EP 4 019 601 A1**
(43) Date of publication of application: **29.06.2022**
(21) Application number: 20889959.1
(22) Date of filing: 17.08.2020
(51) Int. Cl.: C09J 4/06, C09J 11/04, H01L 31/048

(54) **ADHESIVE FILM, ANTI-PID ENCAPSULATION ADHESIVE FILM, COMPOSITION FORMING ADHESIVE FILM, AND PHOTOVOLTAIC MODULE AND LAMINATED GLASS**

(30) Priority: 19.11.2019 CN 201911137294; 30.07.2020 CN 202010753127
(71) Applicant: Hangzhou First Applied Material Co., Ltd., Hangzhou, Zhejiang 311300 (CN)
(72) Inventor: WEI, Mengjuan, Hangzhou, Zhejiang 311300 (CN); ZHOU, Guangda, Hangzhou, Zhejiang 311300 (CN); WANG, Fucheng, Hangzhou, Zhejiang 311300 (CN); HOU, Hongbing, Hangzhou, Zhejiang 311300 (CN); SANG, Yan, Hangzhou, Zhejiang 311300 (CN); DU, Ganhong, Hangzhou, Zhejiang 311300 (CN); LIU, Ting, Hangzhou, Zhejiang 311300 (CN); WANG, Haonan, Hangzhou, Zhejiang 311300 (CN)
(74) Representative: Barker Brettell LLP
(86) International application number: PCT/CN2020/109635
(87) International publication number: WO 2021/098299

(57) **Abstract**

Disclosed are an adhesive film, an anti-PID encapsulation adhesive film, a composition forming the adhesive film, and a photovoltaic module and laminated glass. The composition includes: an ethylene copolymer matrix resin, an amide organic compound, a metal oxide and/or a metal hydroxide, herein the metal oxide is selected from one or more of the components aluminum oxide, calcium oxide, zinc oxide, barium oxide, magnesium oxide, zirconium oxide, titanium oxide, tin oxide, vanadium oxide, antimony oxide, tantalum oxide, niobium oxide, layered transition metal oxide, or ZnO-doped Al₂O₃, CaO/SiO₂-doped Al₂O₃, MgO-doped Al₂O₃, SiO₂-doped ZrO₂, and TiO₂-doped ZrO₂ , and the metal hydroxide is selected from one or more of the components calcium hydroxide, magnesium hydroxide, zinc hydroxide, aluminum hydroxide, iron hydroxide and barium hydroxide. Alternatively, the composition includes: a matrix resin, a metal ion trapping agent and an organic co-crosslinker. The adhesive film has the better anti-PID effect, photoelectric conversion efficiency and encapsulation performance.

## Description

### Technical Field

The present disclosure relates to the field of photoelectric conversion devices, in particular to an adhesive film, an anti-PID encapsulation adhesive film, a composition for forming the same, and a photovoltaic module and laminated glass.

### Background

Photoelectric conversion refers to conversion of solar energy into electrical energy through a photovoltaic effect. Commonly used electronic devices (photoelectric conversion devices) that may achieve the above photoelectric conversion process include but are not limited to a solar cell (such as a crystalline silicon cell, an amorphous silicon cell, a cadmium telluride cell, a copper indium gallium tin cell, and a perovskite cell), a liquid crystal panel, an electroluminescent device, a plasma display device, a sensor and the like, and are usually sealed with one or more layers of a polymer material. And the sealing material is bonded to upper and lower two substrates to form a complete electronic device module. For example, a crystalline silicon solar cell module, it is usually laminated according to a front layer glass substrate, a front sealing layer polymer, a crystalline silicon cell, a rear sealing layer polymer, a rear layer glass substrate or a polymer substrate, and then heated and pressurized by a vacuum laminator to form a complete solar module.

A Potential Induced Degradation (PID) effect, also known as potential induced degradation, is an important aspect of photovoltaic module efficiency degradation, and a generation mechanism thereof is usually intertwined with other factors that affect the photovoltaic module power degradation. A leakage current generated due to a difference between a potential of a photovoltaic module frame and a potential of a solar cell provided in the photovoltaic module causes the overall performance of a photovoltaic system to be reduced, so that a fill factor (FF), a short circuit current (Isc), and an open circuit voltage (Voc) are decreased. And in a severe case, the power of the module may be attenuated by more than 50%, so that the power generation is seriously reduced, and the revenue of an entire photovoltaic power station is affected. So far, there is no clear conclusion on a real cause of PID caused, and it is generally believed in the industry that three aspects of polarization, Na ion migration and electrochemical corrosion are main causes of cell PID caused. A PID mechanism is mainly as follows: 1) Water vapor enters the module: the water vapor is easily generated in a humid and high-temperature environment, and the water vapor enters into the module through an edge-sealing silica gel or a backplane; after a night, a condensation phenomenon may occur (especially dew in summer and autumn) on the surface of the crystalline silicon photovoltaic module, and it may cause that a Na⁺ ion is dissociated from glass during a period of time after the sun rises in the morning and in the case that the surface of the photovoltaic system is relatively wet, and a system negative bias voltage is withstood. 2) Water causes an ethylene-vinyl acetate copolymer (EVA) to be hydrolyzed to generate an acetic acid: an ester bond of EVA reacts after encountering the water, to generate the freely moved acetic acid. 3) The acetic acid reacts with an alkali precipitated on the glass surface to generate freely moved Na+: after the freely moved acetic acid (CH₃COOH) reacts with the alkali precipitated on the glass surface in the case of high-temperature and high-humidity, the freely moved Na+ is generated, and Na+ is moved from the glass to the surface of a cell piece under the action of voltage, the moving speed of a positive ion is affected by an adhesive film, a temperature, a humidity and a voltage, and the sodium ions are diffused into the cell to supply atoms and are enriched on an antireflection layer. 4) Under the action of bias voltage, the leakage current flows from cell piece → EVA → glass surface → frame → bracket, and finally flows to the ground, the output power is attenuated, and a PID phenomenon occurs, thus the photovoltaic effect of the cell is affected.

In allusion to the above problems, there are usually two solution methods in the industry: the first method is to use borosilicate glass to reduce free metal ions such as sodium and calcium in an existing glass cover plate, or use a polyolefin (POE) film (ethylene-octene copolymer film) to replace a traditional ethyl vinyl acetate (EVA) film (ethylene-vinyl acetate copolymer film), as to improve the water vapor barrier properties of the photovoltaic module, and improve the PID phenomenon; and the second method is to arrange a dielectric film layer on the inside of the glass cover plate to block the ions from migrating toward the cell, thereby the PID phenomenon is weaken.

An existing document (CN105950039A) provides an anti-PID polyolefin adhesive film for a solar module, and EVA is replaced with POE as an encapsulation material, as to improve the volume resistivity of the adhesive film, but the price of a polyolefin resin raw material is relatively high, and the encapsulation cost of the module is improved. In addition, the POE material has large cohesive energy and poor adhesion to the glass, so it is easy to produce delamination of the adhesive film and the glass after being used outdoor for a long time.

Another existing document (CN103421443B) provides an encapsulation adhesive film for a solar cell module, the encapsulation adhesive film includes a polyolefin barrier layer and a first adhesive layer and a second adhesive layer (siloxane-grafted polymer and ethylene-alpha olefin composition or siloxane-grafted polymer and EVA composition) located at two sides of the barrier layer. Due to the introduction of the siloxane-grafted copolymer, the encapsulation adhesive film may solve a problem of the poor adhesion between the adhesive film and the glass and the cell piece, but the encapsulation adhesive film may only be used for anti-PID of a conventional cell piece module. The anti-PID effect on a double-face cell piece module is not ideal.

In addition, in an aspect of an encapsulation material production process: DupontTM of the United States provides a PID protective film of a Dupont ionic polymer, the PID protective film is prepared on the basis of an ionic polymer technology verified by more than 15 years of a crystalline silicon module experiment, and the thickness is about 50 µm. It is placed between the photovoltaic glass and the EVA encapsulation adhesive film, as to effectively block the sodium ions from migrating to the surface of the cell piece, and completely solve the PID problem. But the price of the material is relatively expensive, the promotion and application thereof in the market are limited.

In an aspect of a cell piece production process, another existing document (CN104576826B) further provides a cell piece post-treatment method, a non-stick coating layer is prepared on the surface of an aluminum back surface field, as to improve the compactness of a silicon nitride film, and a subsequent high-temperature annealing process improves the PID resistance of the cell piece. But this method increases the manufacturing cost of the cell piece, and it is not beneficial to save the cost of the photovoltaic module.

Based on the above problems, it is necessary to develop an encapsulation adhesive film with both low cost and anti-PID performance.

### Summary

A main purpose of the present disclosure is to provide an adhesive film, an anti-PID encapsulation adhesive film, a composition for forming the same, a photovoltaic module and a laminated glass, as to solve a problem that an existing encapsulation adhesive film may not satisfy requirements of both low cost and anti-PID performance.

In order to achieve the above purpose, according to one aspect of the present disclosure, a composition for forming an adhesive film is provided, and the composition for forming the adhesive film includes: an ethylene copolymer matrix resin, an amide organic compound, a metal oxide and/or a metal hydroxide, herein the metal oxide is selected from one or more of the components aluminum oxide, calcium oxide, zinc oxide, barium oxide, magnesium oxide, zirconium oxide, titanium oxide, tin oxide, vanadium oxide, antimony oxide, tantalum oxide, niobium oxide, layered transition metal oxide, or ZnO-doped Al₂O₃, CaO/SiO₂-doped Al₂O₃, MgO-doped Al₂O₃, SiO₂-doped ZrO₂, and TiO₂-doped ZrO₂, and the metal hydroxide is selected from one or more of the components calcium hydroxide, magnesium hydroxide, zinc hydroxide, aluminum hydroxide, iron hydroxide and barium hydroxide; or in parts by weight, the composition for forming the adhesive film includes: 100 parts of a matrix resin, 0.01~5 parts of a metal ion trapping agent and 0.01~5 parts of an organic co-crosslinker.

Further, the layered transition metal oxide is A₂M₁₂X₆ or A₃M₂X₆, herein, A is Na or Li; M is +2-valent metal; X is Sb, Bi, Nb or Ru; and preferably, the layered transition metal oxide is Na₃Ni₂Sb₆ and/or Li₃Ni_{1.5}Mg_{0.5}Sb₆.

Further, the amide organic compound has a structure shown in Formula (I).

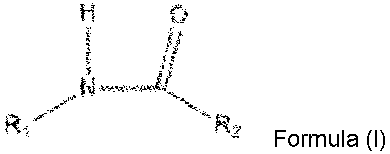

R₁ is H, a group A, a substituent formed by substituting at least one hydrogen atom in the group A with a hydroxyl, an amino or an epoxy, or a substituent formed by substituting at least one methylene in the group A with a carbonyl or an ether bond, the group A is a straight-chain alkyl, a branched-chain alkyl or a cycloalkyl, and the number of carbon atoms of the group A is ≤10; the number of carbon atoms of R₂ is 2~20; and R₂ is selected from vinyl, propenyl, butenyl, pentenyl, hexenyl, heptenyl, octenyl, decaenyl, undecenyl, dodecenyl, tetradecenyl, hexadeceryl or octadecenyl.

Further, the amide organic compound is selected from one or more in a group consisting of acrylamide, methacrylamide, N-methacrylamide, N-ethylacrylamide, N,N'-dimethylacrylamide, N-isopropylacrylamide, N-tert-butylacrylamide, N-methylolacrylamide, N-hydroxyethylacrylamide, N- (2-hydroxypropyl) acrylamide, N,N'-methylenebisacrylamide, maleyl imine, oleic acid amide, 9-hexadecenamide, N- (2-hydroxyethyl) -undec-10-enamide, 9-tetradecenamide, 9-dodecenamide, 9-decenamide, octanamide, heptamide, hexanamide, pentanamide, and butanamide.

Further, the melt index of the ethylene copolymer matrix resin is 0.5~45 g/10 min, preferably 3~20 g/10 min, and more preferably 5~10 g/10 min.

Further, the ethylene copolymer matrix resin is selected from one or more in a group consisting of ethylene-polar monomer copolymer, ethylene-alpha-olefin copolymer and ethylene-cycloolefin copolymer.

Further, the ethylene copolymer matrix resin is the ethylene-polar monomer copolymer, and a polar monomer for forming the ethylene-polar monomer copolymer is an unsaturated carboxylic acid, an unsaturated acid anhydride, an unsaturated carboxylic acid salt, an unsaturated carboxylic acid ester, an amide formed by the unsaturated carboxylic acid, a vinyl ester, a carbon monoxide or a sulfur dioxide; preferably, the unsaturated carboxylic acid is selected from acrylic acid, methacrylic acid, fumaric acid or itaconic acid; preferably, the unsaturated acid anhydride is selected from maleic anhydride or itaconic anhydride; preferably, the unsaturated carboxylic acid salt is selected from lithium salt, sodium salt, potassium salt, magnesium salt, calcium salt or zinc salt formed by the following carboxylic acids: acrylic acid, methacrylic acid, fumaric acid, itaconic acid, maleic anhydride or itaconic anhydride; preferably, the unsaturated carboxylic acid ester is selected from one or more in a group consisting of methyl acrylate, ethyl acrylate, isopropyl acrylate, isobutyl acrylate, n-butyl acrylate, isooctyl acrylate, ethyl methacrylate, isobutyl methacrylate, dimethyl maleate, vinyl acetate, vinyl ester, vinyl propionate, monomethyl maleate and monoethyl maleate.

Further, the ethylene copolymer matrix resin is an ethylene-alpha-olefin copolymer, and the ethylene-alpha-olefin copolymer is a copolymer of ethylene and at least one alpha-olefin with less than 10 carbon atoms; and preferably, the alpha-olefin with less than 10 carbon atoms is selected from propylene, 1-butene, 1-hexene, 1-pentene, 1-octene or 4-methyl-1-pentene.

Further, the ethylene copolymer matrix resin is an ethylene-cycloolefin copolymer, and a cycloolefin for forming the ethylene-cycloolefin copolymer is selected from one or more of cyclopentene, norbornene, vinyl norbornene or ethylidene norbornene.

Further, in parts by weight, the composition for forming the adhesive film includes 100 parts of the ethylene copolymer matrix resin, 0.05~1.5 parts of the amide organic compound, 0.01~10 parts of the metal oxide and/or 0.01~10 parts of the metal hydroxide; and preferably, in parts by weight, the composition for forming the adhesive film includes 100 parts of the ethylene copolymer matrix resin, 0.05~1.5 parts of the amide organic compound, 0.01~3 parts of the metal oxide and/or 0.01~3 parts of the metal hydroxide.

Further, the composition for forming the adhesive film further includes one or more in a group consisting of an organic peroxide, a co-crosslinker, a light stabilizer, an ultraviolet light absorber, a tackifier, an antioxidant and a pigment; preferably, calculated in 100 parts of the ethylene copolymer matrix resin by weight, the composition further includes 0.01~3 parts of the crosslinker by weight, 0.01~10 parts of the co-crosslinker by weight, 0~1.0 part of the light stabilizer by weight, 0~0.4 parts of the ultraviolet light absorber by weight, 0~3.0 parts of the tackifier by weight, 0~0.5 parts of the antioxidant by weight and 0~40 parts of the pigment by weight.

Further, in parts by weight, the composition for forming the adhesive film includes: 100 parts of the matrix resin, 0.05~1 part of the metal ion trapping agent, and 0.1~1 part of the organic co-crosslinker.

Further, in parts by weight, the composition for forming the adhesive film includes: 100 parts of the matrix resin, 0.05~0.5 parts of the metal ion trapping agent, and 0.1~1 part of the organic co-crosslinker.

Further, the metal ion trapping agent is selected from one or more of aluminosilicate, hydrated oxide, polyvalent metal acid salt, metal phosphate, pentavalent metal oxide, hexavalent metal oxide, 7-valent metal oxide, xanthic acid organic compound and dithiocarbamate organic compound; and preferably, the metal ion trapping agent is selected from one or more of aluminum phosphate, titanium phosphate, tin phosphate, zirconium phosphate and bismuth phosphate.

Further, the organic co-crosslinker is selected from a multifunctional acrylate compound and/or a (methyl) acrylamide compound; preferably, the multifunctional acrylate compound is selected from one or more of trimethylolpropane triacrylate, pentaerythritol triacrylate and ethoxylated trimethylolpropane triacrylate; and preferably, the (methyl) acrylamide compound is selected from one or more of N,N'-methylenebisacrylamide, N,N'-vinylbisacrylamide and N-propylacrylamide.

Further, the matrix resin is selected from one or more of ethylene vinyl acetate copolymer, low-density polyethylene, polypropylene, polybutene, polyvinyl butyral, metallocene catalyzed polyethylene, ethylene octene copolymer, ethylene pentene copolymer, ethylene methyl acrylate copolymer and ethylene methyl methacrylate copolymer.

Further, in parts by weight, the composition for forming the adhesive film further includes 0.5~ 5 parts of an auxiliary agent, and the auxiliary agent is selected from one or more of a peroxide crosslinker, an antioxidant, a hindered amine light stabilizer, an ultraviolet light absorber and a tackifier.

Another aspect of the present application further provides an adhesive film, the adhesive film is a single-layer adhesive film or a multi-layer co-extruded adhesive film, and at least one layer of the single-layer adhesive film or the multi-layer adhesive film is prepared by the above composition for forming the adhesive film as a raw material through a melt extrusion process.

Another aspect of the present application further provides an anti-PID encapsulation adhesive film, the anti-PID encapsulation adhesive film is prepared by the above composition for forming the adhesive film as a raw material.

Another aspect of the present application further provides a photovoltaic module, including an encapsulation adhesive film, and the encapsulation adhesive film includes at least one layer of the above adhesive film.

Further, the above photovoltaic module is a double-glass module.

Another aspect of the present application further provides a laminated glass, at least two glass layers and an organic polymer intermediate film arranged between the adjacent glass layers, the organic polymer intermediate film includes at least one layer of the above adhesive film. A technical scheme of the present disclosure is applied, and the ethylene copolymer matrix resin has a good flexibility and light transmittance as the matrix resin for forming the adhesive film, so it is selected as the matrix resin for forming the adhesive film, and it is beneficial to improve the photoelectric conversion efficiency and encapsulation performance of the adhesive film.

The technical scheme of the present disclosure is applied, the addition of the metal oxide and/or the metal hydroxide may increase an initial electromotive force of the ethylene copolymer matrix resin, bind and fix the metal ions in an electric field environment, form a positively charged metal oxide or metal hydroxide, reduce the movement power of the metal ions in the photovoltaic module, and reduce the metal ions in the photovoltaic module; at the same time, some metal oxides (such as a calcium oxide and a zinc oxide) may also chemically react with water in the module, and the calcium hydroxide may physically adsorb the water, reduce the water vapor in the module, and inhibit a decomposition of EVA to generate an acetic acid; at the same time, this type of the metal oxide and/or metal hydroxide may also react with the acetic acid generated by the decomposition of EVA, the acid in a system that reacts with a sodium silicate in the glass is reduced, thereby the generation of the sodium ions in the system is reduced; and therefore, the addition of the metal oxide and/or metal hydroxide described in the present application may suppress the PID phenomenon for a long time.

Both the layered transition metal oxide and doped metal oxide have a certain Na-intercalation reactivity, and the phase transition caused by the order of Na-vacancy may be easily suppressed by substitution or doping. A honeycomb ordered oxide stabilized structure suitable for a sodium ion intercalation reaction is constructed so that X uniformly stabilizes the laminated framework structure to reduce the free sodium ions in the photovoltaic module and achieve the effect of anti-PID.

The amide compound contains a positive group (-CONH-), it may adsorb and bridge with suspended particles dispersed in the photovoltaic module, has a strong flocculation effect on the positively charged metal oxide or metal hydroxide, and form a stable system with neutral electricity, so the metal ions in the photovoltaic module are further reduced. At the same time, the amide compound may improve the cross-linking density of the adhesive film. On one hand, it may improve the ion barrier property in the adhesive film and hinder the migration of the sodium ions; and on the other hand, it may improve the water vapor barrier property of the adhesive film, reduce the water vapor in the module, inhibit the hydrolysis of EVA, reduce the acid in the system that reacts with the sodium silicate in the glass, and reduce the generation of the sodium ions.

Under the mutual synergistic effect of the above amide organic compound and the above metal oxide and/or metal hydroxide, the anti-PID effect of the adhesive film may be greatly improved. In conclusion, the adhesive film formed by the above composition has a long-term effective anti-PID performance, and also has a good photoelectric conversion efficiency and encapsulation performance.

### Detailed Description of the Embodiments

It should be noted that embodiments in the present application and features of the embodiments may be combined with each other in the case without conflicting. The present disclosure is described in detail below with reference to the embodiments.

As described in the background, an existing encapsulation adhesive film may not satisfy requirements of both low cost and anti-PID performance. In order to solve the above technical problem, a typical embodiment of the present application provides a composition for forming an adhesive film, and the composition for forming the adhesive film includes: an ethylene copolymer matrix resin, an amide organic compound, a metal oxide and/or a metal hydroxide, herein the metal oxide is selected from one or more of the components aluminum oxide, calcium oxide, zinc oxide, barium oxide, magnesium oxide, zirconium oxide, titanium oxide, tin oxide, vanadium oxide, antimony oxide, tantalum oxide, niobium oxide, layered transition metal oxide, or ZnO-doped Al₂O₃, CaO/SiO₂-doped Al₂O₃, MgO-doped Al₂O₃, SiO₂-doped ZrO₂, and TiO₂-doped ZrO₂, and the metal hydroxide is selected from one or more of the components calcium hydroxide, magnesium hydroxide, zinc hydroxide, aluminum hydroxide, iron hydroxide and barium hydroxide.

As a matrix resin for forming the adhesive film, the ethylene copolymer matrix resin has a good flexibility and light transmittance, so it is selected as the matrix resin for forming the adhesive film, and it is beneficial to improve the photoelectric conversion efficiency and encapsulation performance of the adhesive film. The addition of the metal oxide and/or the metal hydroxide may increase an initial electromotive force of the ethylene copolymer matrix resin, bind and fix the metal ions in an electric field environment, form a positively charged metal oxide or metal hydroxide, reduce the movement power of the metal ions in the photovoltaic module, and reduce the metal ions in the photovoltaic module; at the same time, some metal oxides (such as a calcium oxide and a zinc oxide) may also chemically react with water in the module, and the calcium hydroxide may physically adsorb the water, reduce the water vapor in the module, and inhibit a decomposition of EVA to generate an acetic acid; at the same time, this type of the metal oxide and/or metal hydroxide may also react with the acetic acid generated by the decomposition of EVA, the acid in a system that reacts with a sodium silicate in the glass is reduced, thereby the generation of the sodium ions in the system is reduced; and therefore, the addition of the metal oxide and/or metal hydroxide described in the present application may suppress the PID phenomenon for a long time. In addition, both the layered transition metal oxide and doped metal oxide have a certain Na-intercalation reactivity, and the phase transition caused by the order of Na-vacancy may be easily suppressed by substitution or doping. A honeycomb ordered oxide stabilized structure suitable for a sodium ion intercalation reaction is constructed so that X uniformly stabilizes the laminated framework structure to reduce the free sodium ions in the photovoltaic module and achieve the effect of anti-PID. The amide compound contains a positive group (-CONH-), it may adsorb and bridge with suspended particles dispersed in the photovoltaic module, has a strong flocculation effect on the positively charged metal oxide or metal hydroxide, and form a stable system with neutral electricity, so the metal ions in the photovoltaic module are further reduced. At the same time, the amide compound may improve the cross-linking density of the adhesive film. On one hand, it may improve the ion barrier property in the adhesive film and hinder the migration of the sodium ions; and on the other hand, it may improve the water vapor barrier property of the adhesive film, reduce the water vapor in the module, inhibit the hydrolysis of EVA, reduce the acid in the system that reacts with the sodium silicate in the glass, and reduce the generation of the sodium ions. Under the mutual synergistic effect of the above amide organic compound and the above metal oxide and/or metal hydroxide, the anti-PID effect of the adhesive film may be greatly improved. In conclusion, the adhesive film formed by the above composition has a long-term effective anti-PID performance, and also has a good photoelectric conversion efficiency and encapsulation performance. At the same time, the preparation process of the adhesive film is simple, and the process cost may be greatly reduced.

Preferably, the above layered transition metal oxide is A₂M₁₂X₆ or A₃M₂X₆, herein, A is Na or Li; M is a +2-valent metal; X is Sb, Bi, Nb or Ru. In the structure of the above layered transition metal oxide, M acts as an active center, to achieve the intercalation and de-intercalation of a sodium ion; X acts as an inert component, and it may stabilize a crystal structure; and a honeycomb of M and X has the orderliness, so that X forms a uniform and stable laminated framework structure. Compared with other layered transition metal oxides, the layered transition metal oxide of the above component also has a more uniform and stable laminated framework, so it is selected as the metal oxide in the present application, and it is beneficial to further improve the anti-PID performance thereof. More preferably, the above layered transition metal oxide is Na₃Ni₂Sb₆ and/or Li₃Ni_{1.5}Mg_{0.5}Sb₆.

In a preferred embodiment, the above amide organic compound has a structure shown in Formula (I).

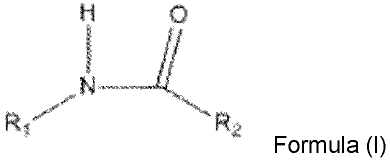

R₁ is H, a group A, a substituent formed by substituting at least one hydrogen atom in the group A with a hydroxyl, an amino or an epoxy, or a substituent formed by substituting at least one methylene in the group A with a carbonyl or an ether bond, the group A is a straight-chain alkyl, a branched-chain alkyl or a cycloalkyl, and the number of carbon atoms of the group A is ≤10; R₂ is a straight-chain alkyl, a branched-chain alkyl, a cycloalkyl or an alkenyl, and the number of carbon atoms of R₂ is 2~20; and the metal oxide may react with water to form an alkali.

Compared with the alkyl, while R₂ is the alkenyl, R₂ may react with the matrix resin, so that the crosslinking degree of the adhesive film may be further improved, this is beneficial to further improve the anti-PID performance of the adhesive film. In a preferred embodiment, R₂ includes, but is not limited to, vinyl, propenyl, butenyl, pentenyl, hexenyl, heptenyl, octenyl, decaenyl, undecenyl, dodecenyl, tetradecenyl, hexadecenyl or octadecenyl. More preferably, the amide organic compound is selected from one or more in a group consisting of acrylamide, methacrylamide, N-methacrylamide, N-ethylacrylamide, N,N'-dimethylacrylamide, N-isopropylacrylamide, N-tert-butylacrylamide, N-methylolacrylamide, N-hydroxyethylacrylamide, N-(2-hydroxypropyl) acrylamide, N,N'-methylenebisacrylamide, maleyl imine, oleic acid amide, 9-hexadecenamide, N-(2-hydroxyethyl) -undec-10-enamide, 9-tetradecenamide, 9-dodecenamide, 9-decenamide, octanamide, heptamide, hexanamide, pentanamide, and butanamide.

If a density of a copolymer is too high, it may affect the light transmittance of the adhesive film; and if the density is too low, the ethylene copolymer matrix resin may become sticky and affect the processing performance. In order to have both a light transmittance and processing performance of the adhesive film, preferably, a melt index of the ethylene copolymer matrix resin is 0.5~45 g/10 min, preferably 3~20 g/10 min, and more preferably 5~10 g/10 min.

In the above composition for forming the adhesive film, the ethylene copolymer matrix resin may be selected from types commonly used in the field. In a preferred embodiment, the ethylene copolymer matrix resin includes, but is not limited to, one or more in a group consisting of ethylene-polar monomer copolymer, ethylene-alpha-olefin copolymer and ethylene-cycloolefin copolymer.

In a preferred embodiment, the ethylene copolymer matrix resin is an ethylene-polar monomer copolymer, and a polar monomer for forming the ethylene-polar monomer copolymer includes, but is not limited to, an unsaturated carboxylic acid, an unsaturated acid anhydride, an unsaturated carboxylic acid salt, an unsaturated carboxylic acid ester, an amide formed by the unsaturated carboxylic acid, a vinyl ester, a carbon monoxide or a sulfur dioxide. The use of the above polar monomer to polymerize with the ethylene to form the ethylene copolymer matrix resin may improve its polarity, and this is beneficial to greatly improve the surface performance and adhesion of the formed adhesive film thereof, and improve its processing performance.

Preferably, the unsaturated carboxylic acid is selected from acrylic acid, methacrylic acid, fumaric acid or itaconic acid; preferably, the unsaturated acid anhydride is selected from maleic anhydride or itaconic anhydride; preferably, the unsaturated carboxylic acid salt is selected from lithium salt, sodium salt, potassium salt, magnesium salt, calcium salt or zinc salt formed by the following carboxylic acids: acrylic acid, methacrylic acid, fumaric acid, itaconic acid, maleic anhydride or itaconic anhydride; preferably, the unsaturated carboxylic acid ester is selected from one or more in a group consisting of methyl acrylate, ethyl acrylate, isopropyl acrylate, isobutyl acrylate, n-butyl acrylate, isooctyl acrylate, ethyl methacrylate, isobutyl methacrylate, dimethyl maleate, vinyl acetate, vinyl ester, vinyl propionate, monomethyl maleate and monoethyl maleate.

In a preferred embodiment, the ethylene copolymer matrix resin is an ethylene-alpha-olefin copolymer, and the ethylene-alpha-olefin copolymer is a copolymer of ethylene and at least one alpha-olefin with less than 10 carbon atoms. The ethylene-alpha-olefin copolymer has a more excellent water vapor barrier property, higher insulating property and higher light transmittance. Used as the matrix resin of the adhesive film, it is beneficial to further improve the water vapor barrier property, insulating property and light transmittance of the adhesive film. More preferably, the alpha-olefin with less than 10 carbon atoms is selected from propylene, 1-butene, 1-hexene, 1-pentene, 1-octene or 4-methyl-1-pentene.

In a preferred embodiment, the ethylene copolymer matrix resin is an ethylene-cycloolefin copolymer, and a cycloolefin for forming the ethylene-cycloolefin copolymer is selected from one or more of cyclopentene, norbornene, vinyl norbornene or ethylidene norbornene. The ethylene-cycloolefin copolymer has a good ultraviolet light transmittance, good dimensional stability, and easy processing. The ethylene-cycloolefin copolymer itself is a non-polar resin, so it has a high barrier property to a polar solvent such as water. This is beneficial to further improve the anti-PID performance of the adhesive film formed by the above composition.

The addition of the metal oxide and/or metal hydroxide and the amide organic compound in the composition for forming the adhesive film is beneficial to greatly improve the anti-PID performance of the adhesive film. In a preferred embodiment, in parts by weight, the above composition for forming the adhesive film includes 100 parts of the ethylene copolymer matrix resin, 0.05~1.5 parts of the amide organic compound, 0.01~10 parts of the metal oxide and/or 0.01~10 parts of the metal hydroxide. The amount of each component in the composition for forming the adhesive film includes, but is not limited to, the above range, it is limited within the above range and may exert sufficiently synergy between the components, and thereby it is beneficial to further improve the comprehensive performance, such as the anti-PID performance, of the adhesive film. More preferably, in parts by weight, the composition for forming the adhesive film includes 100 parts of the ethylene copolymer matrix resin, 0.05~1.5 parts of the amide organic compound, 0.01~3 parts of the metal oxide and/or 0.01~3 parts of the metal hydroxide.

In order to further improve the comprehensive performance of the adhesive film formed by the above composition, in a preferred embodiment, the above composition for forming the adhesive film further includes one or more in a group consisting of an organic peroxide, a co-crosslinker, a light stabilizer, an ultraviolet light absorber, a tackifier, an antioxidant and a pigment. The addition of the crosslinker and co-crosslinker is beneficial to improve the cross-linking degree of the co-extruded adhesive film in the lamination process, so that it has advantages of a stable product performance, not easy to delaminate, and a good mechanical property and a barrier property, and it is beneficial to further improve the power generation efficiency in the application process thereof. The addition of the light stabilizer, the ultraviolet light absorber and the antioxidant is beneficial to improve the anti-aging and anti-oxidation properties of the co-extruded adhesive film, thereby it is beneficial to improve its service life. The addition of the tackifier is beneficial to improve the adhesive property of the adhesive film, thereby it is beneficial to improve its peel strength. The addition of the pigment may satisfy needs of different uses. More preferably, calculated in 100 parts of the ethylene copolymer matrix resin by weight, the above composition for forming adhesive film further includes 0.01~3 parts of the crosslinker by weight, 0.01~10 parts of the co-crosslinker by weight, 0~1.0 part of the light stabilizer by weight, 0~0.4 parts of the ultraviolet light absorber by weight, 0~3.0 parts of the tackifier by weight, 0~0.5 parts of the antioxidant by weight and 0~40 parts of the pigment by weight.

The crosslinker is a molecule with a plurality of ethylenically unsaturated groups that may promote a cross-linking of the polymer to achieve a higher cross-linking degree. In the above composition, the crosslinker may be selected from types commonly used in the field, preferably, the crosslinker includes, but is not limited to, one or more in a group consisting of tert-butyl isopropyl peroxycarbonate, 2,5-dimethyl-2,5- (bis-tert-butylperoxy) hexane, tert-butyl carbonate peroxide-2-ethylhexyl ester, 1,1-bis (tert-butylperoxy) -3,3,5-trimethylcyclohexane, 1,1-bis (tert-amylperoxy) -3,3,5-trimethylcyclohexane, 1,1-bis (tert-amylperoxy) cyclohexane, 1,1-bis (tert-butylperoxy) cyclohexane, 2,2-bis (tert-butylperoxy) butane, 2-ethylhexyl peroxide tert-amyl carbonate, 2,5-dimethyl 2,5-dimethyl 2,5-dimethyl 2,5-bis (benzoyl peroxide) -hexane, tert-amyl carbonate peroxide and tert-butyl peroxide 3,3,5-trimethylhexanoate.

In a preferred embodiment, the co-crosslinker includes, but is not limited to, one or more in a group consisting of triallyl isocyanurate, triallyl cyanurate, trimethylolpropane triacrylate, trimethylolpropane trimethacrylate, pentaerythritol triacrylate, tris (2-hydroxyethyl) isocyanurate triacrylate, ethoxylated trimethylolpropane triacrylate, propoxylated trimethylolpropane triacrylate, ethoxylated glycerol triacrylate, propoxylated glycerol triacrylate, pentaerythritol tetraacrylate, ethoxylated pentaerythritol tetraacrylate, trimethylolpropane tetraacrylate, ditrimethylolpropane tetraacrylate, ditrimethylolpropane tetramethacrylate, propoxylated pentaerythritol tetraacrylate, 2,4,6-tris (2-propenyloxy) -1,3,5-triazine, tricyclodecanedimethanol diacrylate, propoxylated neopentyl glycol diacrylate, ethoxylated bisphenol A diacrylate, ethoxylated bisphenol A dimethacrylate, 2-butyl-2-ethyl-1,3-propanediol diacrylate, diethylene glycol dimethacrylate, triethylene glycol dimethacrylate and polyethylene glycol dimethacrylate.

The antioxidant is used to improve the stability in the polymer extrusion processing and long-term use processes, and delay a degradation due to thermal oxidation. In a preferred embodiment, the antioxidant is a hindered phenolic compound and/or a phosphite compound. Compared with other antioxidants, the above antioxidant has a better stability and antioxidant property. More preferably, the hindered phenolic compound includes, but is not limited to, one or more in a group consisting of 2,6-di-tert-butyl-4-ethylphenol, 2,2'-methylene-bis-(4-methyl-6-tert-butylphenol), 2,2'-methylene-bis-(4-ethyl-6-tert-butylphenol), 4,4'-butylene-bis-(3-methyl-6-tert-butylphenol), octadecyl-3- (3,5-di-tert-butyl-4-hydroxyphenyl) propionate, pentaerythritol-tetra[3- (3,5-di-tert-butyl-4-hydroxylphenyl) propionate], 7-octadecyl-3-(4'-hydroxy-3',5'-di-tert-butylphenyl) propionate, and tetra-[methylene-3-(3',5'-di-tert-butyl-4'-hydroxyphenyl) propionate]methane; and the phosphite compound includes, but is not limited to, one or more in a group consisting of tris (2,4-di-tert-butylphenyl) phosphite, bis[2,4-bis (1,1-dimethylethyl) -6-methylphenyl]ethyl phosphite, tetra (2,4-di-tert-butylphenyl) [1,1-diphenyl]-4,4'-diylbisphosphite and bis (2,4-di-tert-butylphenyl) pentaerythritol diphosphite.

The ultraviolet light absorber refers to a substance that may absorb most of ultraviolet energy and convert it into heat, thereby certain electronic devices are protected from an ultraviolet ray. In a preferred embodiment, the above ultraviolet light absorber includes, but is not limited to, benzophenones and/or benzotriazoles, more preferably, the ultraviolet light absorber includes, but is not limited to, one or more in a group consisting of 2-hydroxy-4-n-octyloxybenzophenone, 2,2-tetramethylenebis (3,1-benzoxazin-4-one), 2-(2'-hydroxy-5-methylphenyl) benzotriazole and 2,2'-dihydroxy-4,4'-dimethoxybenzophenone.

The light stabilizer is used to improve a stability of the encapsulation adhesive film under a long-term ultraviolet radiation. Preferably, the light stabilizer is a hindered amine compound. In a preferred embodiment, the light stabilizer includes, but is not limited to, one or more in a group consisting of bis (2,2,6,6-tetramethyl-4-piperidinyl) sebate, bis (1-octyloxy-2,2,6,6-Tetramethyl-4-piperidinyl) sebate, a graft copolymer obtained by polymerization of 4- (methyl) acryloyloxy-2,2,6,6-tetramethylpiperidine and α-olefin monomer, 4-hydroxy-2,2,6,6-tetramethyl-1-piperidinol, 3,5-di-tert-butyl-4-hydroxy-benzoic acid cetyl ester, bis-2,2,6,6-tetramethylpiperidinol sebacic acid and tris (1,2,2,6,6-pentamethyl-4-piperidinyl) phosphite.

The addition of the tackifier may improve the adhesive property of the adhesive film. In a preferred embodiment, the tackifier includes, but is not limited to, one or more in a group consisting of γ-aminopropyltriethoxysilane, γ-methacryloyloxypropyltrimethoxysilane, γ-(2,3-epoxypropoxy) propyltrimethoxysilane, vinyltrimethoxysilane, N- (β-aminoethyl) -γ-aminopropyltrimethoxysilane, γ-glycidyl etheroxypropyltrimethylsilane, and 3-aminopropyltrimethylsilane.

The addition of the pigment may satisfy different application scenarios according to the customer needs. In a preferred embodiment, the pigment includes, but is not limited to, one or more of the following substances mixed in any proportions: calcium carbonate, barium sulfate, talc, titanium dioxide, zinc oxide, carbon black, graphene, graphene oxide, copper chrome black, magnesium hydroxide, aluminum hydroxide, aluminum oxide, magnesium oxide, boron nitride, silicon carbide, ammonium phosphate, ammonium polyphosphate, pentaerythritol, dipentaerythritol, polypentaerythritol ester, melamine polyphosphate borate.

Another aspect of the present application further provides an adhesive film, the adhesive film of the present application is a single-layer adhesive film or a multi-layer adhesive film, and at least one layer of the above single-layer adhesive film or multi-layer adhesive film is prepared by the above composition for forming the adhesive film as a raw material through a melt extrusion process.

As a matrix resin for forming the adhesive film, the ethylene copolymer matrix resin has a good flexibility and light transmittance, so selected as the matrix resin for forming the adhesive film, it is beneficial to improve the photoelectric conversion efficiency and encapsulation performance of the adhesive film. Under the mutual synergistic effect of the amide organic compound and the above metal oxide and/or metal hydroxide, the anti-PID effect of the adhesive film may be greatly improved. In conclusion, the adhesive film formed by the above composition has the long-term effective anti-PID performance, and also has the good photoelectric conversion efficiency and encapsulation performance.

Another aspect of the present application further provides a laminated glass, including at least two glass layers and an organic polymer intermediate film arranged between the adjacent glass layers, the organic polymer intermediate film includes at least one layer of the above adhesive film provided by the present application.

The above adhesive film provided by the present application has a better encapsulation performance and barrier performance, it is used as the organic polymer intermediate film in the laminated glass, and it is beneficial to greatly improve the lamination performance and barrier performance of the laminated glass.

Another preferred embodiment of the present application provides a composition for forming an anti-PID encapsulation adhesive film, in parts by weight, the composition includes: 100 parts of a matrix resin, 0.01~5 parts of a metal ion trapping agent and 0.01~5 parts of an organic co-crosslinker.

In the above composition for forming the anti-PID encapsulation adhesive film, the addition of the metal ion trapping agent may capture metal cations, thereby the concentration of free metal ions is reduced. At the same time, the addition of the organic co-crosslinker may increase the cross-linking density of the encapsulation adhesive film and increase a barrier performance of the encapsulation adhesive film, thereby the barrier effect of the encapsulation adhesive film on the metal ions is enhanced, and the speed of the metal ions migrating to the surface of the cell piece is reduced. The above two components are added to the matrix resin, and the amount of the three components is limited within the above range. On one hand, the synergistic effect of the metal ion trapping agent and the organic co-crosslinker may effectively reduce the occurrence of the PID phenomenon in the photovoltaic module (especially a double-face cell), and on the other hand, it may also improve the compatibility of the three components, and then the uniformity and performance stability of the encapsulation adhesive film formed therefrom are improved.

In order to further improve the performance stability of the encapsulation adhesive film formed by the above composition, and reduce the occurrence probability of the PID phenomenon in the photovoltaic module (especially the double-face cell), in a preferred embodiment, in parts by weight, the composition includes: 100 parts of the matrix resin, 0.05~1 part of the metal ion trapping agent, and 0.1~1 part of the organic co-crosslinker. More preferably, in parts by weight, the above composition includes: 100 parts of the matrix resin, 0.05~0.5 parts of the metal ion trapping agent and 0.1~1 part of the organic co-crosslinker.

The above metal ion trapping agent may be selected from types commonly used in the field, and the metal ion trapping agent includes, but is not limited to, one or more of aluminosilicate, hydrated oxide, polyvalent metal acid salt, metal phosphate, pentavalent metal oxide, hexavalent metal oxide, 7-valent metal oxide, xanthic acid organic compound and dithiocarbamate organic compound. In order to further improve the capture performance of the metal ion trapping agent for the metal cations, in a preferred embodiment, the metal ion trapping agent includes, but is not limited to, one or more of aluminum phosphate, titanium phosphate, tin phosphate, zirconium phosphate and bismuth phosphate.

The above organic co-crosslinker may be selected from types commonly used in the field, such as a multifunctional acrylate compound and/or a (methyl) acrylamide compound. In a preferred embodiment, the multifunctional acrylate compound includes, but is not limited to, one or more of trimethylolpropane triacrylate, pentaerythritol triacrylate and ethoxylated trimethylolpropane triacrylate. In a preferred embodiment, the (methyl) acrylamide compound includes, but is not limited to, one or more of N,N'-methylenebisacrylamide, N,N'-vinylbisacrylamide and N-propylacrylamide. Compared with other organic crosslinkers, the above several organic crosslinkers may further improve the cross-linking density of the encapsulation adhesive film, increase the barrier performance of the encapsulation adhesive film, thereby the barrier effect of the encapsulation adhesive film on the metal ions is further enhanced, and the speed of the metal ions migrating to the surface of the cell piece is reduced.

In a preferred embodiment, the above matrix resin includes, but is not limited to, one or more of ethylene vinyl acetate copolymer, low-density polyethylene, polypropylene, polybutene, polyvinyl butyral, metallocene catalyzed polyethylene, ethylene octene copolymer, ethylene pentene copolymer, ethylene methyl acrylate copolymer, and ethylene methyl methacrylate copolymer. Compared with other resins, the use of the above matrix resin is beneficial to further improve the uniformity and performance stability of the encapsulation adhesive film formed therefrom.

In order to further improve the comprehensive performance of the above encapsulation adhesive film, in a preferred embodiment, in parts by weight, the above composition further includes 0.5~5 parts of an auxiliary agent, and the auxiliary agent is selected from one or more of a peroxide crosslinker, an antioxidant, a hindered amine light stabilizer, an ultraviolet light absorber and a tackifier.

The above encapsulation adhesive film may be prepared by a method commonly used in the field. Another aspect of the present application further provides a preferred preparation method for an encapsulation adhesive film, and it includes: using the above composition for forming the anti-PID encapsulation adhesive film as a raw material, and performing melt extrusion and calendaring, to obtain the required encapsulation adhesive film.

Another aspect of the present application further provides an anti-PID encapsulation adhesive film, and the anti-PID encapsulation adhesive film is prepared by the above composition as a raw material.

In the above composition for forming the anti-PID encapsulation adhesive film, the addition of the metal ion trapping agent may capture the metal cations, thereby the concentration of the free metal ions is reduced. At the same time, the addition of the organic co-crosslinker may increase the cross-linking density of the encapsulation adhesive film and increase the barrier performance of the encapsulation adhesive film, thereby the barrier effect of the encapsulation adhesive film on the metal ions is enhanced, and the speed of the metal ions migrating to the surface of the cell piece is reduced. The above two components are added to the matrix resin, and the amount of the three components is limited within the above range. On one hand, the synergistic effect of the metal ion trapping agent and organic co-crosslinker may effectively reduce the occurrence of the PID phenomenon in the photovoltaic module (especially the double-face cell), and on the other hand, it may also improve the compatibility of the three components, and then the uniformity and performance stability of the encapsulation adhesive film formed therefrom are improved. On this basis, while the encapsulation adhesive film prepared by the above composition as the raw material is applied to a solar module (especially a double-sided solar cell), the occurrence probability of the PID phenomenon may be effectively reduced.

Another aspect of the present application further provides a photovoltaic module, including an encapsulation adhesive film, and the encapsulation adhesive film includes the adhesive film provided by the present application.

The above adhesive film provided by the present application has a better anti-PID performance, and also has a good photoelectric conversion efficiency and encapsulation performance. It is used as the encapsulation adhesive film of the photovoltaic module, and it is beneficial to greatly improve the power generation efficiency of the photovoltaic module. Preferably, the above photovoltaic module is a double-glass module.

The present application is further described in detail below with reference to specific embodiments, and these embodiments should not be construed as limiting a scope of protection claimed by the present application.

Embodiments about first implementation mode:

### Embodiment 1

100 parts of ethylene-vinyl acetate (26% vinylacetate (VA) content, DuPont, the United States of America) is taken, 100 parts of the above matrix resin by weight is taken as a benchmark, 0.1 parts of a magnesium oxide, 1 part of N,N'-dimethylacrylamide, 0.5 parts of crosslinker isopropyl tert-butyl peroxycarbonate, 0.5 parts of co-crosslinker trimethylolpropane trimethacrylate, 1 part of tackifier vinyl triperoxide tert-butyl silane, and 0.8 parts of light stabilizer bis-2,2,6,6-tetramethylpiperidinol sebacic acid are added. It is mixed uniformly, and the above mixture is subjected to working procedures such as pre-mixing, melt extrusion, film-casting, cooling, slitting and winding, to obtain the anti-PID encapsulation material.

### Embodiment 2

A difference from Embodiment 1 is that: the metal oxide is a calcium oxide.

### Embodiment 3

A difference from Embodiment 1 is that: the metal oxide is a zinc oxide.

### Embodiment 4

A difference from Embodiment 1 is that: 0.05 parts of an aluminum oxide and 0.05 parts of a calcium hydroxide are added.

### Embodiment 5

A difference from Embodiment 1 is that: the metal oxide is a zirconium oxide.

### Embodiment 6

A difference from Embodiment 1 is that: 0.1 parts of a magnesium hydroxide is added.

### Embodiment 7

A difference from Embodiment 1 is that: the metal oxide is MgO-doped Al₂O₃.

### Embodiment 8

A difference from Embodiment 1 is that: the metal oxide is CaO/SiO₂-doped Al₂O₃.

### Embodiment 9

A difference from Embodiment 1 is that: the metal oxide is Li₃Ni_{1.5}Mg_{0.5}Sb₆.

### Embodiment 10

A difference from Embodiment 1 is that: the amide organic compound is N,N-dimethylformamide.

### Embodiment 11

A difference from Embodiment 1 is that: the amide organic compound is N- (2hydroxyethyl) -undec-10-enamide.

### Embodiment 12

A difference from Embodiment 1 is that: the ethylene copolymer is an ethylene-octene copolymer.

### Embodiment 13

A difference from Embodiment 1 is that: the ethylene copolymer is an ethylene-norbornene copolymer.

### Embodiment 14

A difference from Embodiment 1 is that: 0.01 parts of a magnesium oxide and 1.5 parts of N,N'-dimethylacrylamide are added.

### Embodiment 15

A difference from Embodiment 1 is that: 3 parts of a magnesium oxide and 1.5 parts of N,N'-dimethylacrylamide are added.

### Embodiment 16

A difference from Embodiment 1 is that: 12 parts of a magnesium oxide and 0.03 parts of N,N'-dimethylacrylamide are added.

### Embodiment 17

A difference from Embodiment 1 is that: 20 parts of a titanium dioxide is added to preparre a white anti-PID encapsulation material.

### Embodiment 18

A difference from Embodiment 17 is that: 10 parts of a magnesium oxide is added to prepare a white anti-PID encapsulation material.

### Embodiment 19

The adhesive film is a double-layer co-extruded adhesive film formed by a first adhesive film layer and a second adhesive film layer.

The composition of the first adhesive film layer is as follows:
100 parts of ethylene-vinyl acetate (26% VA content, DuPont, USA) is taken, 100 parts of the above matrix resin by weight is taken as a benchmark, 0.1 parts of a magnesium oxide, 1 part of N,N'-dimethylacrylamide, 0.5 parts of crosslinker isopropyl tert-butyl peroxycarbonate, 0.5 parts of co-crosslinker trimethylolpropane trimethacrylate, 1 part of tackifier vinyl triperoxide tert-butyl silane, and 0.8 parts of light stabilizer bis-2,2,6,6-tetramethylpiperidinol sebacic acid are added.

The composition of the second adhesive film layer is as follows:
100 parts of an ethylene-octene copolymer is taken, 100 parts of the above matrix resin by weight is taken as a benchmark, 0.1 parts of a magnesium oxide, 1 part of N,N'-dimethylacrylamide, 0.5 parts of crosslinker isopropyl tert-butyl peroxycarbonate, 0.5 parts of co-crosslinker trimethylolpropane trimethacrylate, 1 part of tackifier vinyl triperoxide tert-butyl silane, and 0.8 parts of light stabilizer bis-2,2,6,6-tetramethylpiperidinol sebacic acid are added.

After the above compositions of resins and auxiliary agents of the first adhesive film layer and the second adhesive film layer are mixed uniformly, they are added to different extruders. An extruded material of the first adhesive film layer and an extruded material of the second adhesive film layer are respectively melted and plasticized, and then injected into the same die head, and merged in the T type die head to form a melt stream, it is subjected to working procedures such as melt extrusion, film-casting, cooling, slitting and winding, to prepare a double-layer composite photovoltaic encapsulation adhesive film EVA-POE, through the calculation of a distributor, the thickness of the first adhesive film layer of the obtained encapsulation adhesive film is 0.2 mm, and the thickness of the second adhesive film layer is 0.3 mm.

### Embodiment 20

The adhesive film is a three-layer co-extruded adhesive film formed by a first adhesive film layer, a second adhesive film layer and a third adhesive film layer.

The composition of the first adhesive film layer is as follows:
100 parts of ethylene-vinyl acetate (26% VA content, DuPont, USA) is taken, 100 parts of the above matrix resin by weight is taken as a benchmark, 0.1 parts of a calcium oxide, 1 part of N-(2-hydroxyethyl) -undecarbon-10-enamide, 0.5 parts of crosslinker isopropyl tert-butyl peroxycarbonate, 0.5 parts of co-crosslinker trimethylolpropane trimethacrylate, 1 part of tackifier vinyl triperoxide tert-butyl silane, and 0.8 parts of light stabilizer bis-2,2,6,6-tetramethylpiperidinol sebacic acid are added.

The composition of the second adhesive film layer is as follows:
100 parts of an ethylene-octene copolymer is taken, 100 parts of the above matrix resin by weight is taken as a benchmark, 0.5 parts of crosslinker isopropyl tert-butyl peroxycarbonate, 0.5 parts of co-crosslinker trimethylolpropane trimethacrylate, 1 part of tackifier vinyl triperoxide tert-butyl silane, and 0.8 parts of light stabilizer bis-2,2,6,6-tetramethylpiperidinol sebacic acid are added.

The composition of the third adhesive film layer is as follows:
100 parts of ethylene-vinyl acetate (26% VA content, DuPont, USA) is taken, 100 parts of the above matrix resin by weight is taken as a benchmark, 3 parts of a magnesium oxide, 1 part of N-(2-hydroxyethyl)-undecarbon-10-enamide, 0.5 parts of crosslinker isopropyl tert-butyl peroxycarbonate, 0.5 parts of co-crosslinker trimethylolpropane trimethacrylate, 1 part of tackifier vinyl triperoxide tert-butyl silane, and 0.8 parts of light stabilizer bis-2,2,6,6-tetramethylpiperidinol sebacic acid are added.

After the above compositions of resins and auxiliary agents of the first adhesive film layer, the second adhesive film layer and the third adhesive film layer are mixed uniformly, they are added to different extruders. An extruded material of the first adhesive film layer, an extruded material of the second adhesive film layer and an extruded material of the third adhesive film layer are respectively melted and plasticized, and then injected into the same die head, and merged in the T type die head to form a melt stream, it is subjected to working procedures such as melt extrusion, film-casting, cooling, slitting and winding, to prepare a three-layer composite photovoltaic encapsulation adhesive film EVA-POE-EVA, through the calculation of a distributor, the thicknesses of the first adhesive film layer and the third adhesive film layer of the obtained encapsulation adhesive film are 0.1 mm, and the thickness of the second adhesive film layer is 0.2 mm.

### Contrast embodiment 1

A difference from Embodiment 1 is that: it does not contain a metal oxide.

### Contrast embodiment 2

A difference from Embodiment 1 is that: it does not contain an amide organic compound.

### Contrast embodiment 3

A difference from Embodiment 1 is that: 100 parts of ethylene-vinyl acetate (26% VA content, DuPont, USA) is taken, 100 parts of the above matrix resin by weight is taken as a benchmark, 0.5 parts of crosslinker isopropyl tert-butyl peroxycarbonate, 0.5 parts of co-crosslinker trimethylolpropane trimethacrylate, 1 part of tackifier vinyl triperoxide tert-butyl silane, and 0.8 parts of light stabilizer bis-2,2,6,6-tetramethylpiperidinol sebacic acid are added. They are mixed uniformly, and the above mixture is subjected to working procedures such as melt extrusion, film-casting, cooling, slitting and winding, to prepare the encapsulation material. Methanol is used as a solvent, to prepare dispersion solution of a magnesium oxide, and the concentration is 1.0wt%. Next, the magnesium oxide dispersion solution is sprayed on the above encapsulation material by a rotary encoder (the rotation number is 100 rpm), and then dried at 120°C, to evaporate the methanol solvent to obtain an encapsulation material with a magnesium oxide coating layer.

Performance test:
Embodiments 1 to 20 and Contrast embodiments 1 to 3 are tested for adhesion force and cross-linking degree and compared for lamination features of modules.

### Test items and test methods

### 1. Adhesion force

300 mmx150 mm glass/adhesive film (two layers) /flexible backplane are stacked in sequence and placed in a vacuum laminator, and laminated according to a lamination process at 150°C for 18 minutes, to prepare a laminated module.

The flexible backplane/adhesive film is cut into 10 mm±0.5 mm samples every 5 mm in a width direction to test the adhesion force between the adhesive film and the glass. According to a test method of GB/T 2790-1995, a peeling force between the adhesive film and the glass is tested on a tensile testing machine at a tensile speed of 100 mm/min±10 mm/min, and the arithmetic mean of three tests is taken, and it is corrected to 0.1 N/cm.

### 2. Cross-linking degree

It is tested by a method of heating extraction with xylene. The ratio of the mass undissolved in the xylene to the initial mass is the cross-linking degree. The arithmetic mean of three samples is taken, and the unit is %.

### 3. Appearance evaluation of module lamination

It is laminated according to a lamination sequence of glass/adhesive film/cell piece/adhesive film/glass, and the lamination is performed according to the lamination process of the above adhesive force test, to prepare a standard double-glass solar cell module, the specification of the module is the version of 60 (6x10) cell pieces. According to the different adhesive films, 100 modules are prepared for appearance evaluation. An evaluation standard is based on the occurrence of bubbles, impurities, and delamination between the adhesive film and the cell piece or glass which are used as judgment objects, and it is specifically as follows:
∘: None △: Slight ×: Severe.

### 4. Module PID aging test

A double-face cell is selected, and tested according to IECTS 2804-1:2015. The test conditions are tightened to 85°C and 85% relative humidity (RH), and a negative 1500 V constant direct current voltage is externally applied. After 192 h, the power attenuations of a photovoltaic module before and after a PID test are measured.

Test results are shown in Table 1.

**Table 1**

| | Adhesion force to glass (N/cm) | Cross-linking degree (%) | Module bubbles | Module impurities | Module delamination | PID192 power attenuation (%) | |
|---|---|---|---|---|---|---|---|
| | | | | | | Front | Back |
| Embodiment 1 | 201 | 88.9 | ∘ | ∘ | ∘ | 0.92 | 2.11 |
| Embodiment 2 | 195 | 88.5 | ∘ | ∘ | ∘ | 1.15 | 2.88 |
| Embodiment 3 | 192 | 88.3 | ∘ | ∘ | ∘ | 1.01 | 2.73 |
| Embodiment 4 | 196 | 88.6 | ∘ | ∘ | ∘ | 1.34 | 3.05 |
| Embodiment 5 | 192 | 88.4 | ∘ | ∘ | ∘ | 0.95 | 2.15 |
| Embodiment 6 | 195 | 88.6 | ∘ | ∘ | ∘ | 1.02 | 2.03 |
| Embodiment 7 | 187 | 88.1 | ∘ | ∘ | ∘ | 1.34 | 2.57 |
| Embodiment 8 | 193 | 88.5 | ∘ | ∘ | ∘ | 1.35 | 2.73 |
| Embodiment 9 | 190 | 88.3 | ∘ | ∘ | ∘ | 1.25 | 2.68 |
| Embodiment 10 | 170 | 85.2 | ∘ | ∘ | ∘ | 3.89 | 6.05 |
| Embodiment 11 | 184 | 87.9 | ∘ | ∘ | ∘ | 0.97 | 1.41 |
| Embodiment 12 | 190 | 88.2 | ∘ | ∘ | ∘ | 0.27 | 0.89 |
| Embodiment 13 | 178 | 86.1 | ∘ | ∘ | ∘ | 0.86 | 1.65 |
| Embodiment 14 | 227 | 89.5 | ∘ | ∘ | ∘ | 1.92 | 3.76 |
| Embodiment 15 | 209 | 89.3 | | ∘ | ∘ | 0.86 | 1.92 |
| Embodiment 16 | 158 | 84.2 | ∘ | ∘ | ∘ | 3.95 | 6.27 |
| Embodiment 17 | 190 | 88.3 | ∘ | ∘ | ∘ | 1.28 | 2.73 |
| Embodiment 18 | 185 | 87.9 | ∘ | ∘ | ∘ | 1.34 | 2.91 |
| Embodiment 19 | 179 | 87.4 | ∘ | ∘ | ∘ | 0.30 | 0.93 |
| Embodiment 20 | 172 | 87.1 | ∘ | ∘ | ∘ | 0.39 | 0.98 |
| Contrast embodiment 1 | 141 | 83.7 | ∘ | ∘ | ∘ | 5.38 | 10.63 |
| Contrast embodiment 2 | 190 | 88.2 | X | X | ∘ | 4.21 | 7.44 |
| Contrast embodiment 3 | 171 | 87.3 | X | X | X | 4.92 | 8.57 |

From the above description, it may be seen that the above embodiments of the present disclosure achieve the following technical effects.

It may be seen by comparing Embodiments 1 to 20 with Contrast embodiments 1 and 2 that the adhesive film prepared by the composition provided in the present application has the more excellent comprehensive performance.

It may be seen by comparing Embodiment 1 with Contrast embodiment 3 that the adhesive film prepared by the preparation method provided in the present application has the more excellent comprehensive performance.

It may be seen by comparing Embodiments 1 to 9 that the use of the metal oxide and/or metal hydroxide preferred in the present application is beneficial to improve the comprehensive performance of the adhesive film.

It may be seen by comparing Embodiments 1, and 10 to 11 that the use of the amide organic compound preferred in the present application is beneficial to improve the comprehensive performance of the adhesive film.

It may be seen by comparing Embodiments 1, and 12 to 13 that the use of the ethylene copolymer preferred in the present application is beneficial to improve the comprehensive performance of the adhesive film.

It may be seen by comparing Embodiments 1, and 14 to 20 that limiting the amount of each component in the composition for forming the adhesive film to the preferred range of the present application is beneficial to improve the comprehensive performance of the adhesive film.

Embodiments about second implementation mode:

### Embodiment 1

An anti-PID photovoltaic encapsulation material, in parts by weight, main raw materials thereof are composed as follows: 100 parts of an ethylene-vinyl acetate copolymer (Singapore TPC company, and the VA mass fraction is 28%), 0.2 mass parts of metal ion trapping agent zirconium phosphate (Acros reagent), 1 part of organic co-crosslinker ethoxy trimethylolpropane triacrylate (Sartomer Chemical Co., Ltd.), 0.6 parts of crosslinker tert-butylperoxy 2-ethylhexyl carbonate (Arkema company), 0.5 parts of tackifier γ-methacryloxypropyl trimethoxysilane (Hubei Jingzhou Jianghan Fine Chemical Co., Ltd.), and 0.2 parts of hindered amine light stabilizer bis-2,2,6,6-tetramethylpiperidinol sebacate (Tianjin Rianlon Co., Ltd.). The above raw materials are subjected to working procedures such as pre-mixing, melt extrusion, film-casting, cooling, slitting and winding, to prepare a photovoltaic encapsulation adhesive film E-1 that resists a module PID phenomenon.

### Embodiment 2

An anti-PID photovoltaic encapsulation material, in parts by weight, main raw materials thereof are composed as follows: 100 parts of an ethylene-vinyl acetate copolymer (Singapore TPC company, and the VA mass fraction is 28%), 0.2 mass parts of metal ion trapping agent zirconium phosphate (Acros reagent), 0.1 part of organic co-crosslinker N,N'-methylenebisacrylamide (Bailing Wei Chemical Co., Ltd.), 0.6 parts of crosslinker tert-butylperoxy 2-ethylhexyl carbonate (Arkema company), 0.5 parts of tackifier γ-methacryloxypropyl trimethoxysilane (Hubei Jingzhou Jianghan Fine Chemical Co., Ltd.), and 0.2 parts of hindered amine light stabilizer bis-2,2,6,6-tetramethylpiperidinol sebacate (Tianjin Rianlon Co., Ltd.). The above raw materials are subjected to working procedures such as pre-mixing, melt extrusion, film-casting, cooling, slitting and winding, to prepare a photovoltaic encapsulation adhesive film E-2 that resists a module PID phenomenon.

### Embodiment 3

An anti-PID photovoltaic encapsulation material, in parts by weight, main raw materials thereof are composed as follows: 100 parts of an ethylene-vinyl acetate copolymer (Singapore TPC company, and the VA mass fraction is 28%), 0.05 mass parts of metal ion trapping agent zirconium phosphate (Acros reagent), 0.1 parts of organic co-crosslinker N,N'-methylenebisacrylamide (Bailingwei Chemical Co., Ltd.), 0.6 parts of crosslinker tert-butylperoxy 2-ethylhexyl carbonate (Arkema company), 0.5 parts of tackifier γ-methacryloxypropyl trimethoxysilane (Hubei Jingzhou Jianghan Fine Chemical Co., Ltd.), and 0.2 parts of hindered amine light stabilizer bis-2,2,6,6-tetramethylpiperidinol sebacate (Tianjin Rianlon Co., Ltd.).

The above raw materials are subjected to working procedures such as pre-mixing, melt extrusion, film-casting, cooling, slitting and winding, to prepare a photovoltaic encapsulation adhesive film E-3 that resists a module PID phenomenon.

### Embodiment 4

An anti-PID photovoltaic encapsulation material, in parts by weight, main raw materials thereof are composed as follows: 100 parts of an ethylene-vinyl acetate copolymer (Singapore TPC company, and the VA mass fraction is 28%), 1 mass part of metal ion trapping agent zirconium phosphate (Acros reagent), 0.1 parts of organic co-crosslinker N,N'-methylenebisacrylamide (Bailing Wei Chemical Co., Ltd.), 0.6 parts of crosslinker tert-butylperoxy 2-ethylhexyl carbonate (Arkema company), 0.5 parts of tackifier γ-methacryloxypropyl trimethoxysilane (Hubei Jingzhou Jianghan Fine Chemical Co., Ltd.), 0.2 parts of hindered amine light stabilizer bis-2,2,6,6-tetramethylpiperidinol sebacate (Tianjin Rianlon Co., Ltd.), and 0.3 parts of ultraviolet absorber 2-hydroxy-4-n-octyloxybenzophenone (BASF Chemical Co., Ltd., Germany), the above raw materials are subjected to working procedures such as pre-mixing, melt extrusion, film-casting, cooling, slitting and winding, to prepare a photovoltaic encapsulation adhesive film E-4 that resists a module PID phenomenon.

### Embodiment 5

An anti-PID photovoltaic encapsulation material, in parts by weight, main raw materials thereof are composed as follows: 100 parts of an ethylene-vinyl acetate copolymer (Singapore TPC company, and the VA mass fraction is 28%), 0.2 mass parts of metal ion trapping agent aluminium phosphate (Acros reagent), 0.1 parts of organic co-crosslinker N,N'-methylenebisacrylamide (Bailingwei Chemical Co., Ltd.), 0.6 parts of crosslinker tert-butylperoxy 2-ethylhexyl carbonate (Arkema company), 0.5 parts of tackifier γ-methacryloxypropyl trimethoxysilane (Hubei Jingzhou Jianghan Fine Chemical Co., Ltd.), and 0.2 parts of hindered amine light stabilizer bis-2,2,6,6-tetramethylpiperidinol sebacate (Tianjin Rianlon Co., Ltd.). The above raw materials are subjected to working procedures such as pre-mixing, melt extrusion, film-casting, cooling, slitting and winding, to prepare a photovoltaic encapsulation adhesive film E-5 that resists a module PID phenomenon.

### Embodiment 6

An anti-PID photovoltaic encapsulation material, in parts by weight, main raw materials thereof are composed as follows: 100 parts of an ethylene-vinyl acetate copolymer (Singapore TPC company, and the VA mass fraction is 28%), 0.2 mass parts of metal ion trapping agent zirconium phosphate (Acros reagent), 0.1 parts of organic co-crosslinker trimethylolpropane triacrylate (Bailingwei Chemical Co., Ltd.), 0.6 parts of crosslinker tert-butylperoxy 2-ethylhexyl carbonate (Arkema company), 0.5 parts of tackifier γ-methacryloxypropyl trimethoxysilane (Hubei Jingzhou Jianghan Fine Chemical Co., Ltd.), and 0.2 parts of hindered amine light stabilizer bis-2,2,6,6-tetramethylpiperidinol sebacate (Tianjin Rianlon Co., Ltd.). The above raw materials are subjected to working procedures such as pre-mixing, melt extrusion, film-casting, cooling, slitting and winding, to prepare a photovoltaic encapsulation adhesive film E-6 that resists a module PID phenomenon.

### Embodiment 7

An anti-PID photovoltaic encapsulation material, in parts by weight, main raw materials thereof are composed as follows: 100 parts of an ethylene-vinyl acetate copolymer (Singapore TPC company, and the VA mass fraction is 28%), 0.2 mass parts of metal ion trapping agent bismuth phosphate (Acros reagent), 0.1 parts of organic co-crosslinker trimethylolpropane triacrylate (Bailingwei Chemical Co., Ltd.), 0.6 parts of crosslinker tert-butylperoxy 2-ethylhexyl carbonate (Arkema company), 0.5 parts of tackifier γ-methacryloxypropyl trimethoxysilane (Hubei Jingzhou Jianghan Fine Chemical Co., Ltd.), and 0.2 parts of hindered amine light stabilizer bis-2,2,6,6-tetramethylpiperidinol sebacate (Tianjin Rianlon Co., Ltd.). The above raw materials are subjected to working procedures such as pre-mixing, melt extrusion, film-casting, cooling, slitting and winding, to prepare a photovoltaic encapsulation adhesive film E-7 that resists a module PID phenomenon.

### Embodiment 8

An anti-PID photovoltaic encapsulation material, in parts by weight, main raw materials thereof are composed as follows: 100 parts of an ethylene-vinyl acetate copolymer (Singapore TPC company, and the VA mass fraction is 28%), 0.5 mass parts of metal ion trapping agent zirconium phosphate (Acros reagent), 0.5 parts of organic co-crosslinker trimethylolpropane triacrylate (Bailingwei Chemical Co., Ltd.), 0.6 parts of crosslinker tert-butylperoxy 2-ethylhexyl carbonate (Arkema company), 0.5 parts of tackifier γ-methacryloxypropyl trimethoxysilane (Hubei Jingzhou Jianghan Fine Chemical Co., Ltd.), and 0.2 parts of hindered amine light stabilizer bis-2,2,6,6-tetramethylpiperidinol sebacate (Tianjin Rianlon Co., Ltd.). The above raw materials are subjected to working procedures such as pre-mixing, melt extrusion, film-casting, cooling, slitting and winding, to prepare a photovoltaic encapsulation adhesive film E-8 that resists a module PID phenomenon.

### Contrast embodiment 1

A conventional photovoltaic encapsulation material, in parts by weight, main raw materials thereof are composed as follows: 100 parts of an ethylene-vinyl acetate copolymer (Singapore TPC company, and the VA mass fraction is 28%), 0.6 parts of crosslinker tert-butylperoxy 2-ethylhexyl carbonate (Arkema company), 0.5 parts of tackifier γ-methacryloxypropyl trimethoxysilane (Hubei Jingzhou Jianghan Fine Chemical Co., Ltd.), 1 part of triallyl isocyanurate (Evonik Degussa Co., Ltd.), and 0.2 parts of hindered amine light stabilizer bis-2,2,6,6-tetramethylpiperidinol sebacate (Tianjin Rianlon Co., Ltd.). The above raw materials are subjected to working procedures such as pre-mixing, melt extrusion, film-casting, cooling, slitting and winding, to prepare a photovoltaic encapsulation adhesive film C-1.

### Contrast embodiment 2

An anti-PID photovoltaic encapsulation material, in parts by weight, main raw materials thereof are composed as follows: 100 parts of an ethylene-vinyl acetate copolymer (Singapore TPC company, and the VA mass fraction is 28%), 0.05 parts of zirconium phosphate (Bailingwei Technology Co., Ltd.), 0.2 parts of hindered amine light stabilizer bis-2,2,6,6-tetramethylpiperidinol sebacate (Tianjin Rianlon Co., Ltd.), 0.6 parts of crosslinker tert-butylperoxy 2-ethylhexyl carbonate (Arkema company), 0.5 parts of tackifier γ-methacryloxypropyl trimethoxysilane (Hubei Jingzhou Jianghan Fine Chemical Co., Ltd.), and 1 part of triallyl isocyanurate (Evonik Degussa Co., Ltd.). The above raw materials are subjected to working procedures such as pre-mixing, melt extrusion, film-casting, cooling, slitting and winding, to prepare a photovoltaic encapsulation adhesive film C-2 that resists a module PID phenomenon.

### Contrast embodiment 3

An anti-PID photovoltaic encapsulation material, in parts by weight, main raw materials thereof are composed as follows: 100 parts of an ethylene-vinyl acetate copolymer (Singapore TPC company, and the VA mass fraction is 28%), 1 part of organic co-crosslinker trimethylolpropane triacrylate (Sartomer Chemical Co., Ltd.), 0.2 parts of hindered amine light stabilizer bis-2,2,6,6-tetramethylpiperidinol sebacate (Tianjin Rianlon Co., Ltd.), 0.6 parts of crosslinker tert-butylperoxy 2-ethylhexyl carbonate (Arkema company), and 0.5 parts of tackifier γ-methacryloxypropyl trimethoxysilane (Hubei Jingzhou Jianghan Fine Chemical Co., Ltd.). The above raw materials are subjected to working procedures such as pre-mixing, melt extrusion, film-casting, cooling, slitting and winding, to prepare a photovoltaic encapsulation adhesive film C-3 that resists a module PID phenomenon.

### Performance test

Light transmittance and PID tests are performed on a laminated module prepared by the encapsulation materials of Embodiments 1 ~ 8 and Contrast embodiments 1 ~ 3. After being laminated, the thicknesses of the adhesive films of the embodiments and contrast embodiments are 0.45 nm, herein the light transmittance is measured according to GB/T 2410-2008. The ethyl vinyl acetate (EVA) adhesive films obtained in the above embodiments and contrast embodiments and a P-type double-face cell of Company A are made into a double-face double-glass module through the same process. The photovoltaic module PID test is performed according to IEC TS 2804-1:2015, and the test conditions are tightened to 85°C and 85% RH, and a negative 1500 V constant direct current voltage is externally applied. After 192 h, the power attenuations of a photovoltaic module before and after a PID test are measured, and test results are shown in Table 2.

**Table 2**

| Number | Light transmittance (%) | Photovoltaic module power attenuation after PID test (%) | |
|---|---|---|---|
| | | Front | Back |
| Embodiment 1 | 91.2 | 1.23 | 4.04 |
| Embodiment 2 | 91.2 | 0.78 | 2.86 |
| Embodiment 3 | 91.7 | 1.31 | 3.56 |
| Embodiment 4 | 90.1 | 0.96 | 2.17 |
| Embodiment 5 | 91.0 | 1.58 | 3.04 |
| Embodiment 6 | 90.8 | 1.27 | 3.25 |
| Embodiment 7 | 91.1 | 0.94 | 3.11 |
| Embodiment 8 | 90.7 | 1.22 | 2.79 |
| Contrast embodiment 1 | 92.2 | 3.85 | 28.5 |
| Contrast embodiment 2 | 91.0 | 2.42 | 7.56 |
| Contrast embodiment 3 | 92.3 | 2.64 | 13.25 |

It may be known from the comparison of performance test data of the embodiments and contrast embodiments in Table 2 above:
in Embodiments 1 ~ 8, the addition of the organic co-crosslinker may not affect the light transmittance of the adhesive film. And as the increase of the addition amount of the metal ion adsorbent, the light transmittance tends to decrease. While the dosage of the metal ion trapping agent is less than 1 part by mass, the light transmittance may be kept above 90%, and the anti-PID effect is also good. It is matched with the P-type double-face cell to prepare the double-glass module. Under the test conditions of -1500 V and 196 h, the attenuation powers on both sides of the front face are controlled within 5%, and the actual needs are satisfied.

It may be seen from Contrast embodiment 1 that the photovoltaic encapsulation adhesive film without the metal ion trapping agent and the organic co-crosslinker represents a larger module power attenuation. For the photovoltaic encapsulation adhesive film containing only the zirconium phosphate (Contrast embodiment 2), although the anti-PID performance is improved, the power attenuation on the back of the module is still 7.56%, the anti-PID effect thereof is not ideal. For the photovoltaic encapsulation adhesive film containing only the co-crosslinker trimethylolpropane triacrylate (Contrast embodiment 3), although the anti-PID performance is improved compared with C1 (Contrast embodiment 1), the power attenuation on the back of the module is still more than 10 %, the anti-PID effect thereof is not ideal.

In conclusion, it may be seen from the above embodiments that the adhesive films prepared in each embodiment have the better anti-PID performance.

It should be noted that terms "first", "second" and the like in the description and claims of the present application are used to distinguish similar objects, and are not necessarily used to describe a specific sequence or a precedence order. It is to be understood that the terms so used are interchangeable under appropriate circumstances such that the embodiments of the present application described herein may, for embodiment, be implemented in a sequence other than those described herein.

The above are only preferred embodiments of the present disclosure, and are not intended to limit the present disclosure. For those skilled in the art, the present disclosure may have various modifications and changes. Any modifications, equivalent replacements, improvements and the like made within the spirit and principle of the present disclosure shall be included within a scope of protection of the present disclosure.

## Claims

1. A composition for forming an adhesive film, wherein the composition for forming the adhesive film comprises: an ethylene copolymer matrix resin, an amide organic compound, a metal oxide and/or a metal hydroxide, wherein the metal oxide is selected from one or more of the components aluminum oxide, calcium oxide, zinc oxide, barium oxide, magnesium oxide, zirconium oxide, titanium oxide, tin oxide, vanadium oxide, antimony oxide, tantalum oxide, niobium oxide, layered transition metal oxide, or ZnO-doped Al₂O₃, CaO/SiO₂-doped Al₂O₃, MgO-doped Al₂O₃, SiO₂-doped ZrO₂, and TiO₂-doped ZrO₂, and the metal hydroxide is selected from one or more of the components calcium hydroxide, magnesium hydroxide, zinc hydroxide, aluminum hydroxide, iron hydroxide and barium hydroxide; or
in parts by weight, the composition for forming the adhesive film comprises: 100 parts of a matrix resin, 0.01~5 parts of a metal ion trapping agent and 0.01~5 parts of an organic co-crosslinker.

2. The composition for forming the adhesive film according to claim 1, wherein the layered transition metal oxide is A₂M₁₂X₆ or A₃M₂X₆, wherein, A is Na or Li; M is +2-valent metal; X is Sb, Bi, Nb or Ru; and
preferably, the layered transition metal oxide is Na₃Ni₂Sb₆ and/or Li₃Ni_{1.5}Mg_{0.5}Sb₆.

3. The composition for forming the adhesive film according to claim 1 or 2, wherein the amide organic compound has a structure shown in Formula (I), 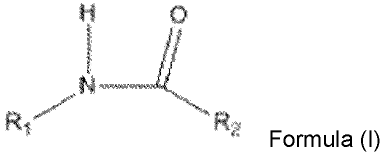 R₁ is H, a group A, a substituent formed by substituting at least one hydrogen atom in the group A with a hydroxyl, an amino or an epoxy, or a substituent formed by substituting at least one methylene in the group A with a carbonyl or an ether bond, the group A is a straight-chain alkyl, a branched-chain alkyl or a cycloalkyl, and the number of carbon atoms of the group A is ≤10; the number of carbon atoms of R₂ is 2~20; and R₂ is selected from vinyl, propenyl, butenyl, pentenyl, hexenyl, heptenyl, octenyl, decaenyl, undecenyl, dodecenyl, tetradecenyl, hexadecenyl or octadecenyl.

4. The composition for forming the adhesive film according to claim 3, wherein the amide organic compound is selected from one or more in a group consisting of acrylamide, methacrylamide, N-methacrylamide, N-ethylacrylamide, N,N'-dimethylacrylamide, N-isopropylacrylamide, N-tert-butylacrylamide, N-methylolacrylamide, N-hydroxyethylacrylamide, N-(2-hydroxypropyl) acrylamide, N,N'-methylenebisacrylamide, maleyl imine, oleic acid amide, 9-hexadecenamide, N- (2-hydroxyethyl) -undec-10-enamide, 9-tetradecenamide, 9-dodecenamide, 9-decenamide, octanamide, heptamide, hexanamide, pentanamide, and butanamide.

5. The composition for forming the adhesive film according to any one of claims 1 to 3, wherein a melt index of the ethylene copolymer matrix resin is 0.5~45 g/10 min, preferably 3~20 g/10 min, and more preferably 5~10 g/10 min.

6. The composition for forming the adhesive film according to claim 4, wherein the ethylene copolymer matrix resin is selected from one or more in a group consisting of ethylene-polar monomer copolymer, ethylene-alpha-olefin copolymer and ethylene-cycloolefin copolymer.

7. The composition for forming the adhesive film according to claim 5, wherein the ethylene copolymer matrix resin is the ethylene-polar monomer copolymer, and a polar monomer for forming the ethylene-polar monomer copolymer is selected from an unsaturated carboxylic acid, an unsaturated acid anhydride, an unsaturated carboxylic acid salt, an unsaturated carboxylic acid ester, an amide formed by the unsaturated carboxylic acid, a vinyl ester, a carbon monoxide or a sulfur dioxide;
preferably, the unsaturated carboxylic acid is selected from acrylic acid, methacrylic acid, fumaric acid or itaconic acid;
preferably, the unsaturated acid anhydride is selected from maleic anhydride or itaconic anhydride;
preferably, the unsaturated carboxylic acid salt is selected from lithium salt, sodium salt, potassium salt, magnesium salt, calcium salt or zinc salt formed by the following carboxylic acids: acrylic acid, methacrylic acid, fumaric acid, itaconic acid, maleic anhydride or itaconic anhydride; and
preferably, the unsaturated carboxylic acid ester is selected from one or more in a group consisting of methyl acrylate, ethyl acrylate, isopropyl acrylate, isobutyl acrylate, n-butyl acrylate, isooctyl acrylate, ethyl methacrylate, isobutyl methacrylate, dimethyl maleate, vinyl acetate, vinyl ester, vinyl propionate, monomethyl maleate and monoethyl maleate.

8. The composition for forming the adhesive film according to claim 5, wherein the ethylene copolymer matrix resin is an ethylene-alpha-olefin copolymer, and the ethylene-alpha-olefin copolymer is a copolymer of ethylene and at least one alpha-olefin with less than 10 carbon atoms; and
preferably, the alpha-olefin with less than 10 carbon atoms is selected from propylene, 1-butene, 1-hexene, 1-pentene, 1-octene or 4-methyl-1-pentene.

9. The composition for forming the adhesive film according to claim 5, wherein the ethylene copolymer matrix resin is an ethylene-cycloolefin copolymer, and a cycloolefin for forming the ethylene-cycloolefin copolymer is selected from one or more of cyclopentene, norbornene, vinyl norbornene or ethylidene norbornene.

10. The composition for forming the adhesive film according to any one of claims 1 to 8, wherein, in parts by weight, the composition for forming the adhesive film comprises 100 parts of the ethylene copolymer matrix resin, 0.05~1.5 parts of the amide organic compound, 0.01~10 parts of the metal oxide and/or 0.01~10 parts of the metal hydroxide; and
preferably, in parts by weight, the composition for forming the adhesive film comprises 100 parts of the ethylene copolymer matrix resin, 0.05~1.5 parts of the amide organic compound, 0.01~3 parts of the metal oxide and/or 0.01~3 parts of the metal hydroxide.

11. The composition for forming the adhesive film according to claim 9, wherein the composition for forming the adhesive film further comprises one or more in a group consisting of an organic peroxide, a co-crosslinker, a light stabilizer, an ultraviolet light absorber, a tackifier, an antioxidant and a pigment; and
preferably, calculated in 100 parts of the ethylene copolymer matrix resin by weight, the composition further comprises 0.01~3 parts of the crosslinker by weight, 0.01~10 parts of the co-crosslinker by weight, 0~1.0 part of the light stabilizer by weight, 0~0.4 parts of the ultraviolet light absorber by weight, 0~3.0 parts of the tackifier by weight, 0~0.5 parts of the antioxidant by weight and 0~40 parts of the pigment by weight.

12. The composition for forming the adhesive film according to claim 1, wherein, in parts by weight, the composition for forming the adhesive film comprises: 100 parts of the matrix resin, 0.05~1 part of the metal ion trapping agent, and 0.1~1 part of the organic co-crosslinker.

13. The composition for forming the adhesive film according to claim 12, wherein, in parts by weight, the composition for forming the adhesive film comprises: 100 parts of the matrix resin, 0.05~0.5 parts of the metal ion trapping agent, and 0.1~1 part of the organic co-crosslinker.

14. The composition for forming the adhesive film according to any one of claims 1 and 12 to 13, wherein the metal ion trapping agent is selected from one or more of aluminosilicate, hydrated oxide, polyvalent metal acid salt, metal phosphate, pentavalent metal oxide, hexavalent metal oxide, 7-valent metal oxide, xanthic acid organic compound and dithiocarbamate organic compound; and
preferably, the metal ion trapping agent is selected from one or more of aluminum phosphate, titanium phosphate, tin phosphate, zirconium phosphate and bismuth phosphate.

15. The composition for forming the adhesive film according to any one of claims 1 and 12 to 13, wherein the organic co-crosslinker is selected from a multifunctional acrylate compound and/or a (methyl) acrylamide compound;
preferably, the multifunctional acrylate compound is selected from one or more of trimethylolpropane triacrylate, pentaerythritol triacrylate and ethoxylated trimethylolpropane triacrylate; and
preferably, the (methyl) acrylamide compound is selected from one or more of N,N'-methylenebisacrylamide, N,N'-vinylbisacrylamide and N-propylacrylamide.

16. The composition for forming the adhesive film according to claim 15, wherein the matrix resin is selected from one or more of ethylene vinyl acetate copolymer, low-density polyethylene, polypropylene, polybutene, polyvinyl butyral, metallocene catalyzed polyethylene, ethylene octene copolymer, ethylene pentene copolymer, ethylene methyl acrylate copolymer and ethylene methyl methacrylate copolymer.

17. The composition for forming the adhesive film according to any one of claims 1 and 12 to 16, wherein, in parts by weight, the composition for forming the adhesive film further comprises 0.5~5 parts of an auxiliary agent, and the auxiliary agent is selected from one or more of a peroxide crosslinker, an antioxidant, a hindered amine light stabilizer, an ultraviolet light absorber and a tackifier.

18. An adhesive film, wherein the adhesive film is a single-layer adhesive film or a multi-layer co-extruded adhesive film, and at least one layer of the single-layer adhesive film or the multi-layer adhesive film is prepared by the composition for forming the adhesive film according to any one of claims 1 to 11 as a raw material through a melt extrusion process.

19. An anti-PID encapsulation adhesive film, wherein the anti-PID encapsulation adhesive film is prepared by the composition for forming the adhesive film according to any one of claims 1 and 12 to 17 as a raw material.

20. A photovoltaic module, comprising an encapsulation adhesive film, wherein the encapsulation adhesive film comprises at least one layer of the adhesive film according to claim 18 or the anti-PID encapsulation adhesive film according to claim 19.

21. The photovoltaic module according to claim 20, wherein the photovoltaic module is a double-glass module.

22. A laminated glass, wherein the laminated glass comprises at least two glass layers and an organic polymer intermediate film arranged between the adjacent glass layers, wherein the organic polymer intermediate film comprises at least one layer of the adhesive film according to claim 18.
